Europäisches Patentamt

European Patent Office

Office européen des brevets

(19)

(11) EP 1 480 093 A1

(12) EUROPEAN PATENT APPLICATION

(43) Date of publication:
24.11.2004 Bulletin 2004/48

(51) Int Cl.⁷: $G05B\ 19/19$, $G03F\ 7/20$, $H04M\ 1/00$

(21) Application number: 04252492.6

(22) Date of filing: 29.04.2004

(84) Designated Contracting States:
AT BE BG CH CY CZ DE DK EE ES FI FR GB GR
HU IE IT LI LU MC NL PL PT RO SE SI SK TR
Designated Extension States:
AL HR LT LV MK

(30) Priority: 13.05.2003 EP 03252965

(71) Applicant: ASML Netherlands B.V.
5504 DR Veldhoven (NL)

(72) Inventor: Dams, Johannes A. A. T.
5509 KD Veldhoven (NL)

(74) Representative: Leeming, John Gerard
J.A. Kemp & Co.,
14 South Square,
Gray's Inn
London WC1R 5JJ (GB)

(54) **Control system, lithographic apparatus, device manufacturing method and device manufactured thereby**

(57) A control system for positioning means 10 comprising a PID type controller 4, or other connected in a feedback loop. The controller calculates a current for supply to the positioning means 10 according to the error between the desired value of current $I_s$ and the measured value of current $I_m$. This current is converted to a voltage by amplifier 6 and further modified by a feedforward voltage $U_{ff}$ calculated using mechanical and electrical characteristics of the positioning means and desired position and/or desired derivatives of position.

Fig. 3

**Description**

The present invention relates to a control system for positioning means comprising:

- a setpoint generator for calculating a desired current or voltage for supply to said positioning means according to a desired position and/or derivatives thereof of said positioning means;
- a controller for outputting a signal to be supplied to said positioning means according to said desired current or voltage; and
- at least one sensor for measuring a present value of current or voltage;

wherein said controller is connected in a feedback loop such that the controller has as its input the error between said desired current or voltage and said measured current or voltage.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undirected light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

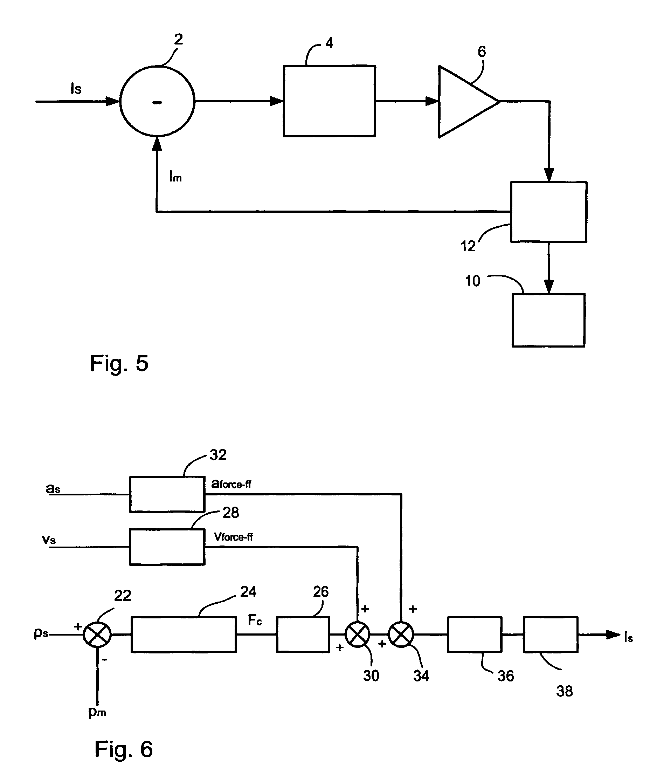

During manufacture it is necessary to move the substrate into the correct position for loading, unloading and exposure. It may also be necessary to move the mask. It is important that any movements are carried out as quickly and accurately as possible, to improve the throughput of the apparatus and the quality of the exposed substrates. Typically movement is controlled by a motion controller based on desired position, velocity and acceleration. The motion controller generates a desired current or voltage to be supplied to an actuator such that the desired position, velocity and acceleration are obtained. This desired current is input to an amplifier control system connected in a feedback loop to ensure the desired current or voltage is supplied to the actuator. A simplified diagram of the control system for a single phase actuator is shown in Figure 5.

The motion controller provides the input of the desired current $I_s$. The present value of the current $I_m$ is measured by the meter 12. $I_m$ is subtracted from $I_s$ by subtractor 2 to give an error which is fed into the controller 4. The current controller calculates a new voltage setpoint, which is then converted by the amplifier 6 into a voltage which is provided to the actuator 10. The controller 4 is typically of the proportional, integral, differential (PID) type.

The parameters of the PID controller 4 are determined by considering the mechanical and electrical characteristics of the system. The response is constrained by the requirement to keep the system stable, accurate and within specified limits of phase difference. These constraints limit the speed at which movement to a desired position can be achieved.

The performance of the system has been improved by adding velocity and acceleration feedforward control into the calculation of the desired current $I_s$ in the motion controller. Such a system is illustrated in Figure 6. A PID controller 24 has an input of the error between the measured position $p_m$ and the position $p_s$ from a setpoint generator. It outputs a force $F_c$ to move into the desired position $p_s$. Notch filter 26 suppresses a specific frequency in the closed loop system, to give better closed loop performance.

Calculators 32 and 28 respectively carry out an acceleration feedforward calculation and a velocity feedforward calculation using the desired values for acceleration $a_s$ and velocity, $v_s$ from the setpoint generator, and knowledge of the mechanical characteristics of the system. The results of the feedforward calculation, $a_{force-ff}$ and $v_{force-ff}$, are added to the output of the notch filter 26. A further notch is added by notch filter 36. Finally the force is converted into a current setpoint $I_s$ by the converter 38 using the motor constant. (The motor constant defines how many Newtons per amp the actuator delivers.)

This modified system has improved response but suffers from the constraints of the current amplifier control system, which uses only feedback control. For example, if a current of 14A is desired it will not be produced instantaneously. The response will be delayed by the requirement to keep the current controller stable and any phase difference in the system. This places limitations on the speed of movement and accuracy of the system.

It is an object of the present invention to improve the accuracy and speed of a movement control system.

This and other objects are achieved according to the invention in a control system as specified in the opening paragraph, characterized by adding at least one feedforward value to the output of the controller before it is supplied to the positioning means, wherein the feedforward value is calculated using mechanical and/or electrical characteristics of said positioning means and the desired position and/or derivatives thereof of the positioning means.

The reference to a desired position and/or derivatives thereof includes position, velocity, acceleration and higher derivatives. The reference to mechanical and/or electrical characteristics includes back-emf, resistance, self inductance and motor constant of the positioning means, as well as the moving mass. The positioning means may be an actuator or a single or multi-phase motor.

Thus, the present invention adds feedforward control into the current or voltage control loop. As described above, feedforward control has been applied to the calculation of a current (or voltage) setpoint but not to the control of the current (or voltage) controller used to reach the setpoint.

By providing an additional feedforward control element the accuracy and speed of the response is increased. The system also suffers less phase delay, allowing higher overall performance and stricter design criteria to be applied.

The limiting factor on the rate of change of current (or voltage) is now determined by the feedforward value and the power stage of the amplifier, rather than the bandwidth of the current (or voltage) control loop. Errors are reduced and thus servo performance increases. Furthermore the behavior of the system is more predictable and controllable, it behaves less like a "black box".

A velocity feedforward value may be calculated using the back-emf of the positioning means (which is known) and the desired velocity of the positioning means. The velocity feedforward value may be calculated by multiplying the back-emf and the desired velocity together.

An acceleration feedforward value may be calculated using the reciprocal of the motor constant of the positioning means, the electrical resistance of the positioning means, the effective moving mass (which are all known) and the desired acceleration of the positioning means. The acceleration feedforward value may be calculated by multiplying these values together.

A jerk feedforward value may be calculated using the reciprocal of the motor constant of the positioning means, the effective moving mass, the self inductance of the positioning means (which are all known) and the desired jerk of the positioning means. "Jerk" is used to refer to the first derivative of acceleration (third derivative of position).

By calculating one or more of the above feedforward values and adding them to the output of the controller the performance is increased. The calculation of the feedforward values is relatively simple and can be implemented without requiring undue complexity in the controller. The values relating to characteristics of the positioning means may be set once and forgotten or refined using knowledge of the performance of the individual system in use. The mechanical values used in the feedforward calculations reflect the mechanics of the positioning means. Thus, if a gear ratio is present between the positioning means and the payload the values used in the feedforward calculations will be need to be modified appropriately.

Higher derivatives of position may also be calculated and included, for example "D-jerk", the first derivative of jerk (fourth derivative of position).

Optionally, the positioning means may be a multiple phase actuator, and further comprise a commutator for each phase for adjusting the value of the desired current or voltage and the feedforward value. This allows the control system to be easily adapted for use with multiple phase actuators. There is no need to alter the calculation of the feedforward value, the result is adjusted by the commutator.

According to a further aspect of the invention there is provided a lithographic projection apparatus comprising :

- a radiation system for providing a projection beam of radiation;
- a support structure for supporting patterning means, the patterning means serving to pattern the projection beam according to a desired pattern;
- a substrate table for holding a substrate;
- first positioning means for moving said substrate table;
- a projection system for projecting the patterned beam onto a target portion of substrate,

characterized in that a control system as described above is used to control said first positioning means.

The lithographic projection apparatus may further comprise:

- second positioning means for moving said patterning means;

wherein a control system as described above is used to control said second positioning means.

Thus, the operation of the lithographic apparatus is improved. The speed of movement of the first and/or second positioning means is increased, allowing greater throughput. Accuracy of the movement is also improved.

According to a further aspect of the invention there is provided a control method for positioning means comprising the steps of:

- calculating a desired current or voltage for supply to positioning means according to a desired position and/or derivatives thereof of said positioning means;
- subtracting a measured current or voltage from said desired current or voltage to calculate an error value;
- inputting said error value to a controller which outputs a signal input to said positioning means;

characterized by:

- calculating a feedforward value using mechanical and/or electrical characteristics of said positioning means and said desired position and/or derivatives thereof of the positioning means; and
- adding said feedforward value to the signal input to said positioning means.

According to a still further aspect of the present invention, there is provided a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material;

wherein the movements of the patterning means and/or the substrate are controlled using a control method as described above.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to a first embodiment of the invention;
Figure 2 depicts a single-phase feedforward control system for a current amplifier according to a first embodiment of the invention;
Figure 3 depicts the calculation of voltage feedforward values in the form of a flow chart according to a first embodiment of the invention;
Figure 4 depicts a feedforward control system for a current amplifier of a multi-phase actuator according to a second embodiment of the present invention;
Figure 5 depicts a standard feedback control system for a current amplifier known in the prior art; and
Figure 6 depicts the use of acceleration and velocity feedforward in the determination of a current setpoint known in the prior art.

In the Figures, corresponding reference symbols indicate corresponding parts.

Embodiment 1

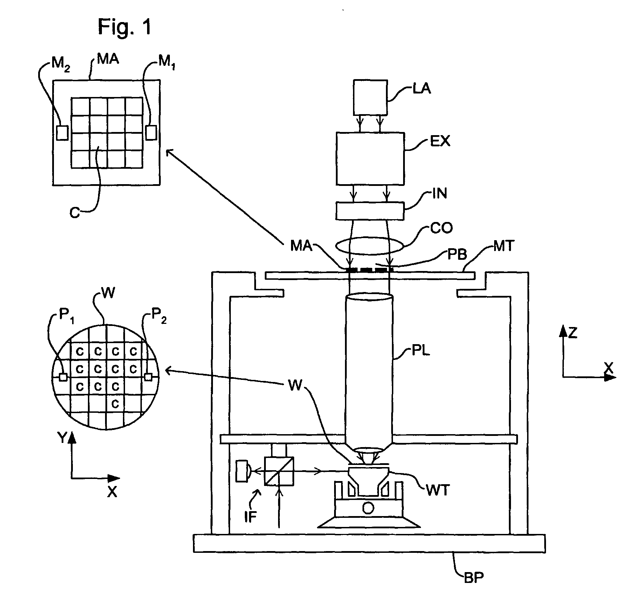

Figure 1 schematically depicts a lithographic projection apparatus according to a particular embodiment of the invention. The apparatus comprises:

- a radiation system Ex, IL, for supplying a projection beam PB of radiation (*e.g.* EUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;

- a projection system ("lens") PL (*e.g.* a mirror group) for imaging an irradiated portion of the mask MA onto a target portion C (*e.g.* comprising one or more dies) of the substrate W.

As here depicted, the apparatus is of a reflective type (*e.g.* has a reflective mask). However, in general, it may also be of a transmissive type, for example (*e.g.* with a transmissive mask). Alternatively, the apparatus may employ another kind of patterning means, such as a programmable mirror array of a type as referred to above.

The source LA (*e.g.* a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

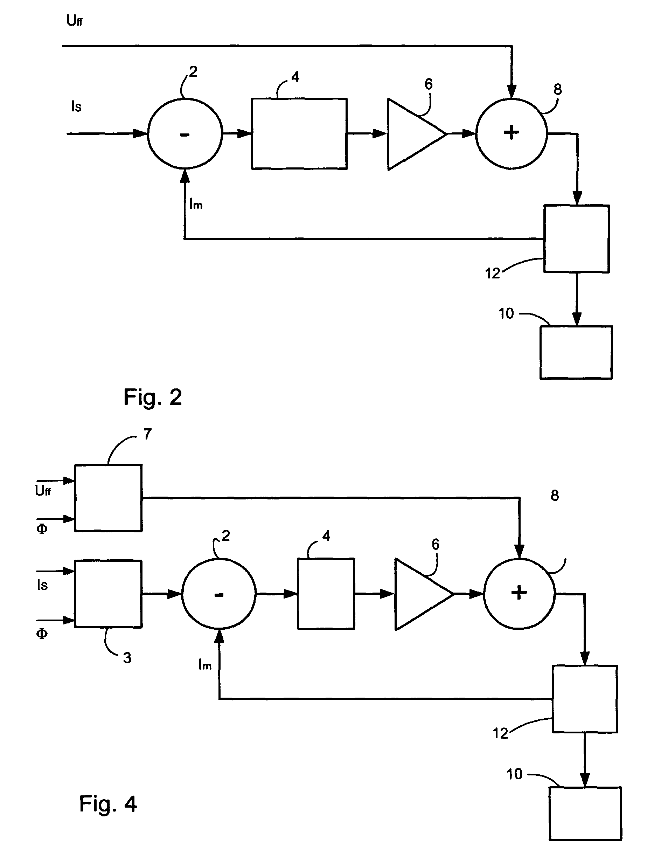

Figure 2 illustrates a current amplifier and control system for a single-phase actuator 10, for example a single phase motor, according to an embodiment of the present invention. Actuator 10 is attached to the wafer table WT. The system of Figure 2 is duplicated for each further actuator attached to the wafer table WT. It may also be duplicated to supply the actuators of the mask table MT if that is movable.

A motion controller (not illustrated) calculates the setpoint current $I_s$ using the desired position, velocity and acceleration of the Wafer Table WT and the measured position. In this embodiment, the method of calculating $I_s$ is the same as that described above in the discussion of the prior art with reference to Figure 5.

The current meter 12 measures the present value $I_m$ of the current through the actuator 10. $I_m$ is then subtracted from the setpoint current $I_s$ by the mixer 2 to give an error value. This error value is then supplied as the input to the current controller 4. The current controller 4 uses control algorithm to determine the value of voltage to be supplied to the actuator in order to reach the setpoint current $I_s$. In this embodiment the control algorithm used is PID, but others such as fuzzy logic or proportional-integral could also be used. An amplifier 6 is then used to supply this voltage to the actuator 10. In this embodiment the current controller 4 is implemented in a programmable DSP, microprocessor, microcontroller or any other type of digital controller and forms part of the overall motion controller. The current controller 4 could also be constructed from discrete components.

A feedforward voltage $U_{ff}$ is also calculated by the motion controller and is added to the output of amplifier 6 by the mixer 8. The resultant voltage is then applied to the actuator 10. The process is repeated continuously as $I_s$

varies according to the desired movements.

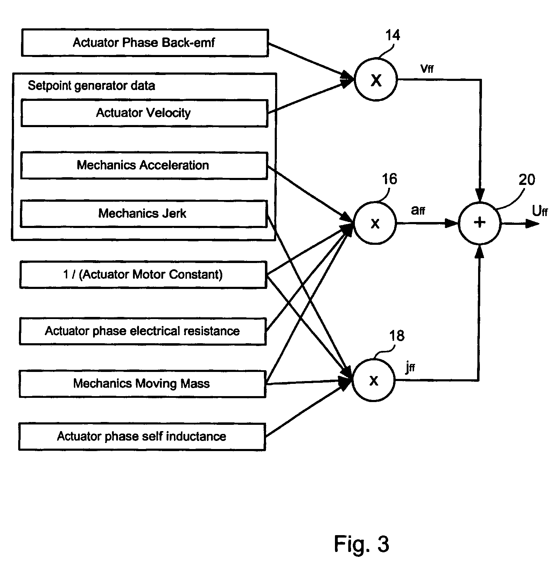

The feedforward voltage $U_{ff}$ calculated in this embodiment comprises three individual components: velocity $v_{ff}$, acceleration $a_{ff}$ and jerk $j_{ff}$ (jerk is the derivative of acceleration). A flow chart showing calculation of the feedforward components is given in Figure 3.

Calculation of the feedforward voltage requires knowledge of several variables. The setpoint generator provides the desired velocity, acceleration and jerk. Additionally the moving mass and four actuator characteristics (back-emf, resistance, self-inductance, and the reciprocal of the motor constant) are stored in the motion controller. These stored values may be updated dynamically as the behavior of the system in use is monitored or calibrated periodically.

The desired values are determined by the setpoint generator according to the movement required and permitted maximum values. During operation it is likely that there will be a maximum acceleration or velocity which cannot be exceeded to avoid risk of damage, etc. These maximums form the constraints that limit the response of the system. For example the maximum value of acceleration will impose a limit on how quickly a given velocity can be achieved.

The velocity feedforward $v_{ff}$ is calculated by multiplying the actuator back-emf and the desired velocity together (illustrated by multiplier 14).

The acceleration feedforward $a_{ff}$ is calculated by multiplying the desired acceleration, actuator resistance, moving mass and reciprocal of the actuator motor constant together (illustrated by multiplier 16).

The jerk feedforward $j_{ff}$ is calculated by multiplying the desired jerk, moving mass, actuator phase self inductance and reciprocal of the actuator motor constant together (illustrated by multiplier 18).

These three feedforward components are added (illustrated by adder 20) to give the final voltage feedforward value $U_{ff}$. $U_{ff}$ is added to the output of the amplifier 6 in figure 2 by adder 8.

The derivation of these feedforward values will now be explained. The voltage across a coil in the actuator comprises three components:

$$U = (IR) + \left( L\frac{dI}{dt} \right) + \left( B_{emf}V \right) = a_{ff} + j_{ff} + v_{ff}$$

Where $U$ is the coil voltage, $I$ is the actuator current, $R$ is the resistance, $L$ is the self inductance of the actuator, $t$ is time, $B_{emf}$ is the back-emf and $V$ is the velocity. Each of the three components can be calculated using the desired value of velocity, acceleration and jerk together with the mechanical and electrical characteristics of the system. The component attributable to velocity, $v_{ff}$, is simply

$$v_{ff} = B_{emf}V$$

The component attributable to acceleration, $a_{ff}$, is calculated as follows:

$$F = ma = KI \Rightarrow I = \frac{ma}{K}$$

$$a_{ff} = IR = \frac{ma}{K}R$$

Where $F$ is force, $K$ is the motor constant, $m$ is the mass of the moving system and $a$ is the desired acceleration. The component attributable to jerk, $j_{ff}$, is calculated by:

$$ma = KI \Rightarrow m\frac{da}{dt} = K\frac{dI}{dt} \Rightarrow mJ_d = K\frac{dI}{dt}$$

$$j_{ff} = L\frac{dI}{dt} = L\frac{mJ_d}{K}$$

Where $J_d$ is the desired jerk. These equations assume that the actuator is directly coupled to the payload. If a gear ratio is used between the actuator and the payload the values of moving mass, desired velocity, desired acceleration and desired jerk will need to be modified appropriately.

The use of a voltage feedforward value improves the response and accuracy of the system with little extra cost. The calculation of the feedforward value is relatively simple and uses readily available data so the controller can be improved with little increase in complexity. The limiting factor on the response is now determined by the feedforward value and not the bandwidth of the current control loop. This leads to a faster response with less phase difference.

Embodiment 2

A second embodiment of the present invention is illustrated in Figure 4. The construction of this embodiment is as for the first embodiment save as described below.

In this embodiment the single-phase actuator of the first embodiment is replaced with a multi-phase actuator 11, for example a three-phase motor. Each phase of the actuator 11 has a corresponding control system as illustrated in Figure 6. Each control system is as for the first embodiment with the addition of a current commutator 3 and a voltage commutator 7. Current commutator 3 has an input of the current setpoint Is and position dependent commutation phase information $\phi$. Voltage commutator 7 has an input of the voltage feedforward $U_{ff}$ and position dependent commutation phase information $\phi$. The position dependent commutation phase information $\phi$, represents the magnetic phase that the coil is experiencing (this is dependent on position).

The current setpoint and the voltage feedforward value are calculated in the same way as for the above described first embodiment. However, this only gives an output of the amplitude required, and does not consider the phase. The current commutator 3 converts the current setpoint $I_s$ from the motion controller into the correct value for that phase, using the position dependent commutation phase information $\phi$. Operation of the voltage commutator 7 is similar for calculating the voltage feedforward for the phase. However, this calculation must also consider that not all of the components in the voltage feedforward will vary with the magnetic phase the coil is experiencing, and so not all the components will need to be commutated.

It is therefore possible to use feedforward control with a multi-phase actuator having an arbitrary number of phases. Very little increase in complexity over the single-phase situation of the first embodiment is required. Furthermore, each calculation of current set-point and voltage feedforward need only be done once, there is no need to repeat it for each phase.

Whilst specific embodiments of the invention has been described above, it will be appreciated that the invention may be practiced otherwise than as described. The description is not intended to limit the invention. In particular, although operation in terms of a current setpoint has been described, the embodiments can be adapted for operation using a voltage setpoint. The embodiments can also be adapted for use with capacitive (Piezo) amplifiers.

Whilst the use of three feedforward components has been described the person skilled in the art will appreciate that more, or less, components could be used according to the requirements of each individual application. In particular, higher derivatives of position than jerk could be included, for example the derivative of jerk (D-jerk).

Although the embodiments have described the use of a DSP or microprocessor based controller, discrete components could be substituted with similar results.

**Claims**

1. A control system for positioning means comprising:

   - a setpoint generator for calculating a desired current or voltage for supply to said positioning means according to a desired position and/or derivatives thereof of said positioning means;
   - a controller for outputting a signal to be supplied to said positioning means according to said desired current or voltage; and
   - at least one sensor for measuring a present value of current or voltage;

   wherein said controller is connected in a feedback loop such that the controller has as its input the error between said desired current or voltage and said measured current or voltage,
   **characterized by**:

   - addition means for adding at least one feedforward value to the output of said controller before it is supplied to the positioning means; and
   - calculation means for calculating said feedforward value using mechanical and/or electrical characteristics of said positioning means and said desired position and/or derivatives thereof of the positioning means.

2. A control system according to Claim 1, **characterized in that** said calculation means calculate a velocity feedforward value using the back-emf of the positioning means and the desired velocity of the positioning means.

3. A control system according to Claim 2, **characterized in that** said calculation means calculate said velocity feedforward value by multiplying said back-emf of the positioning means and said desired velocity of the positioning means together

4. A control system according to any preceding claim, **characterized in that** said calculation means calculate an acceleration feedforward value using the reciprocal of the motor constant of the positioning means, the electrical resistance of the positioning means, the effective moving mass and the desired acceleration of the positioning means.

5. A control system according to Claim 4, **characterized in that** said calculation means calculate said acceleration feedforward value by multiplying said reciprocal of the motor constant of the positioning means, said electrical resistance of the positioning means, said effective moving mass and said desired acceleration of the positioning means together.

6. A control system according to any one of the preceding claims, **characterized in that** said calculation means calculate a jerk feedforward value using the reciprocal of the motor constant of the positioning means, the effective moving mass, the self inductance of the positioning means and the desired jerk of the positioning means.

7. A control system according to Claim 6, **characterized in that** said calculation means calculate said jerk feedforward value by multiplying said reciprocal of the motor constant of the positioning means, said effective moving mass, said self inductance of the positioning means and said desired jerk of the positioning means together.

8. A control system according to any one of the preceding claims, wherein said positioning means is a multiple phase actuator, and further comprising a commutator for each phase for adjusting the value of said desired current or voltage and said feedforward value.

9. A lithographic projection apparatus comprising :

   - a radiation system for providing a projection beam of radiation;
   - a support structure for supporting patterning means, the patterning means serving to pattern the projection beam according to a desired pattern;
   - a substrate table for holding a substrate;
   - first positioning means for moving said substrate table; and
   - a projection system for projecting the patterned beam onto a target portion of substrate,

   **characterized in that** a control system according to any one of Claims 1 to 8 is used to control said first positioning means.

10. A lithographic projection apparatus according to claim 9 further comprising:

   - second positioning means for moving said support structure;

   wherein a control system according to any one of Claims 1 to 8 is used to control said second positioning means.

11. A control method for positioning means comprising the steps of:

   - calculating a desired current or voltage for supply to positioning means according to a desired position and/or derivatives thereof of said positioning means;
   - subtracting a measured current or voltage from said desired current or voltage to calculate an error value; and
   - inputting said error value to a controller which outputs a signal input to said positioning means;

   **characterized by**:

   - calculating a feedforward value using mechanical and/or electrical characteristics of said positioning means and said desired position and/or derivatives thereof of the positioning means; and
   - adding said feedforward value to the signal input to said positioning means.

12. A device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section; and
- projecting the patterned beam of radiation onto a target portion of the layer of radiation-sensitive material;

**characterized in that** the movements of the patterning means and/or the substrate are controlled using a control method according to claim 11.

## Fig. 1

U$_{ff}$

I$_s$

2

4

6

8

I$_m$

12

10

## Fig. 2

7

U$_{ff}$

Φ

I$_s$

Φ

3

2

4

6

8

I$_m$

12

10

## Fig. 4

Actuator Phase Back-emf

14

Vff

X

Setpoint generator data

Actuator Velocity

Mechanics Acceleration

16

aff

X

Mechanics Jerk

20

Uff

+

1 / (Actuator Motor Constant)

Actuator phase electrical resistance

18

jff

Mechanics Moving Mass

X

Actuator phase self inductance

Fig. 3

Fig. 5

Fig. 6

**European Patent Office**

## EUROPEAN SEARCH REPORT

Application Number

EP 04 25 2492

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 4 990 001 A (LOSIC NOVICA A ET AL) 5 February 1991 (1991-02-05) * column 2, line 34 - line 44; figure 1 * * column 4, line 9 - line 13; figure 1 * * column 5, line 40 - line 64 * * column 6, line 29 - line 48 * ----- | 1-3,11 | G05B19/19 G03F7/20 H04M1/00 |
| X | US 4 902 944 A (CASLER JR RICHARD J ET AL) 20 February 1990 (1990-02-20) * column 6, line 16 - line 48; figure 2A * * column 8, line 66 - column 9, line 10 * ----- | 1,8 | |
| Y | EP 1 267 213 A (ASML NETHERLANDS B V) 18 December 2002 (2002-12-18) * page 7, line 11 - line 16 * * page 9, line 52 * * paragraph [0001] * * claim 12 * ----- | 9-12 | |
| Y | EP 1 265 104 A (ASML NETHERLANDS B V) 11 December 2002 (2002-12-11) * page 6, line 5 - line 15; figure 2 * * paragraph [0001] * * claim 10 * ----- | 9-12 | TECHNICAL FIELDS SEARCHED (Int.Cl.7) G08B G03F G05B H04M |
| P,A | EP 1 347 337 A (NIPPON KOGAKU KK) 24 September 2003 (2003-09-24) * page 7, line 53 - page 13, line 22; figure 5 * ----- | 1,9-11 | |

The present search report has been drawn up for all claims

| Place of search | Date of completion of the search | Examiner |
|---|---|---|
| The Hague | 20 September 2004 | Groen, F |

EPO FORM 1503 03.82 (P04C01)

**ANNEX TO THE EUROPEAN SEARCH REPORT
ON EUROPEAN PATENT APPLICATION NO.**                    EP 04 25 2492

This annex lists the patent family members relating to the patent documents cited in the above-mentioned European search report.
The members are as contained in the European Patent Office EDP file on
The European Patent Office is in no way liable for these particulars which are merely given for the purpose of information.

20-09-2004

| Patent document cited in search report | | Publication date | Patent family member(s) | | Publication date |
|---|---|---|---|---|---|
| US 4990001 | A | 05-02-1991 | NONE | | |
| US 4902944 | A | 20-02-1990 | EP | 0268490 A2 | 25-05-1988 |
| EP 1267213 | A | 18-12-2002 | EP | 1267213 A1 | 18-12-2002 |
| | | | JP | 2003068640 A | 07-03-2003 |
| | | | US | 2003016340 A1 | 23-01-2003 |
| EP 1265104 | A | 11-12-2002 | EP | 1265104 A1 | 11-12-2002 |
| | | | EP | 1265106 A2 | 11-12-2002 |
| | | | JP | 2003115450 A | 18-04-2003 |
| | | | US | 2003043354 A1 | 06-03-2003 |
| EP 1347337 | A | 24-09-2003 | US | 2003173556 A1 | 18-09-2003 |
| | | | EP | 1347337 A2 | 24-09-2003 |
| | | | JP | 2004006688 A | 08-01-2004 |

EPO FORM P0459

For more details about this annex : see Official Journal of the European Patent Office, No. 12/82